Europäisches Patentamt

European Patent Office

Office européen des brevets

Veröffentlichungsnummer: **0 300 405**
**A2**

# EUROPÄISCHE PATENTANMELDUNG

(21) Anmeldenummer: 88111514.1

(22) Anmeldetag: 18.07.88

(51) Int. Cl.⁴ **F16L 55/10**

(30) Priorität: 21.07.87 CH 2769/87

(43) Veröffentlichungstag der Anmeldung:
**25.01.89 Patentblatt 89/04**

(84) Benannte Vertragsstaaten:
**CH DE ES FR GB IT LI NL SE**

(71) Anmelder: **Hasler AG**
**Belpstrasse 23**
**CH-3000 Bern 14(CH)**

(72) Erfinder: **Diggelmann, Hans, Dr.**
**Strittenweg 77**
**CH-3176 Neuenegg(CH)**

(74) Vertreter: **Schwerdtel, Eberhard, Dr.**
**c/o Hasler AG Belpstrasse 23**
**CH-3000 Bern 14(CH)**

(54) **Solltrennstelle eines verzweigten Kühlrohrsystems in einem Elektronikgestell.**

(57) Die Solltrennstelle ist ausgebildet als Biegungen in insgesamt zwei Rohren (25) und zugeordnete lösbare Rohrverbindungen (37). Die Biegungen umfassen bei jedem Rohr (25) zwei obenliegende (31, 33) und zwei untenliegende Krümmungen (32, 34), die einander einzeln abwechseln. Im Bereich derjenigen obenliegenden Krümmung (33), die von den jeweils zwei untenliegenden Krümmungen (32, 34) begrenzt wird, liegt die jewilige Rohrverbindung (37).

Im Bedarfsfall wird ein Gefäss (39) mit einem Kältemittel (40) von unten her über die untenliegenden Krümmungen (32, 34) geschoben, wodurch die Flüssigkeit in diesen gefriert und die Rohre (25) an je zwei Stellen absperrt, so dass anschliessend die Rohrverbindungen (37) ohne Flüssigkeitsaustritt gelöst werden können.

Die Solltrennstelle ist gedacht für Elektronikgestelle in Gestellbauweise, die mit Flüssigkeitsunterstützung gekühlt werden.

Fig. 2

## Solltrennstelle eines verzweigten Kühlrohrsystems in einem Elektronikgestell

Die Erfindung betrifft eine Solltrennstelle eines verzweigten Rohrsystems in einem Elektronikgestell nach dem Oberbegriff von Anspruch 1. Sie betrifft weiter ihre Verwendung nach Anspruch 8.

Geschlossene Rohrsysteme mit Natur- oder Zwangsumlauf einer Heiz- oder Kühlflüssigkeit sind bestens bekannt, ebenso diverse Rohrverbindungstechniken zum Aufbau solcher Rohrsysteme. Für gelötete Rohranschlüsse wird beispielsweise die Schrift CH 482 142 genannt.

Aus der Rohrinstallationstechnik ist es weiter allgemein bekannt, im Fall von Reparaturen oder Ergänzungen des Rohrsystems an der vorgesehenen Trennstelle des Rohres mittels einer manschettenartigen Einrichtung und der Wirkung expandierenden Gases, z.B. $CO_2$, die Rohrflüssigkeit, z.B. Wasser, einzufrieren und damit das Rohr an einer oder an meist zwei Stellen gegen den Austritt der Rohrflüssigkeit abzudichten.

Es ist weiter bekannt, Elektronikgestelle, z.B. für Telefonzentralen, mit Luft zu kühlen und die anfallende Wärme direkt oder über eine Klimaanlage an die Aussenwelt abzuführen. Flüssigkeitsunterstützte Kühlung von Elektronikgestellen ist beispielsweise aus dem Patentgesuch CH 5 329/85-2 bekannt. Hierbei wird die anfallende Verlustwärme der Elektronik an eine zentrale Stelle im jeweiligen Gestell gebracht und dort mittels eines Wärmetauschers an einen externen Wärmeträger abgegeben.

Ist der externe Wärmeträger eine Flüssigkeit, insbesondere Wasser, so ergibt sich das Problem einer störungsfreien Flüssigkeitsführung in der Nähe aufwendiger Elektronik über einen langen Zeitraum, z.B. 20 Jahre. Aus Sicherheitsgründen muss hierbei quasi absolut sichergestellt werden, dass niemals Verlustflüssigkeit in den Bereich der Elektronik gelangen kann, was andernfalls sofort Korrosionsschäden und damit den Ausfall der betroffenen Elektronik hervorrufen würde. Aus diesen Gründen ergibt sich als weitere Forderung, dass für den Fall eventueller Reparaturen sichergestellt ist, dass in keinem Elektronikgestell jemals Wärmeträgerflüssigkeit austritt, und dies bei vollem Betrieb benachbarter Gestelle, und bei aus Kosten- und Sicherheitsgründen nicht vorhandenen Absperrventilen oder -hahnen.

Die Aufgabe der Erfindung besteht nun darin, eine Vorrichtung anzugeben, die die genannten Forderungen preisgünstig erfüllt.

Im folgenden wird die Erfindung anhand von 4 Figuren beispielsweise näher beschrieben. Es zeigen:

Fig. 1 - Schematische Ansicht von mehreren Elektronikgestellen mit integriertem Kühlrohrsystem;

Fig. 2 - Schematischer Aufbau einer ersten Solltrennstelle;

Fig. 3 - Sschematischer Aufbau einer zweiten Solltrenstelle;

Fig. 4 - Detail einer Solltrennstelle.

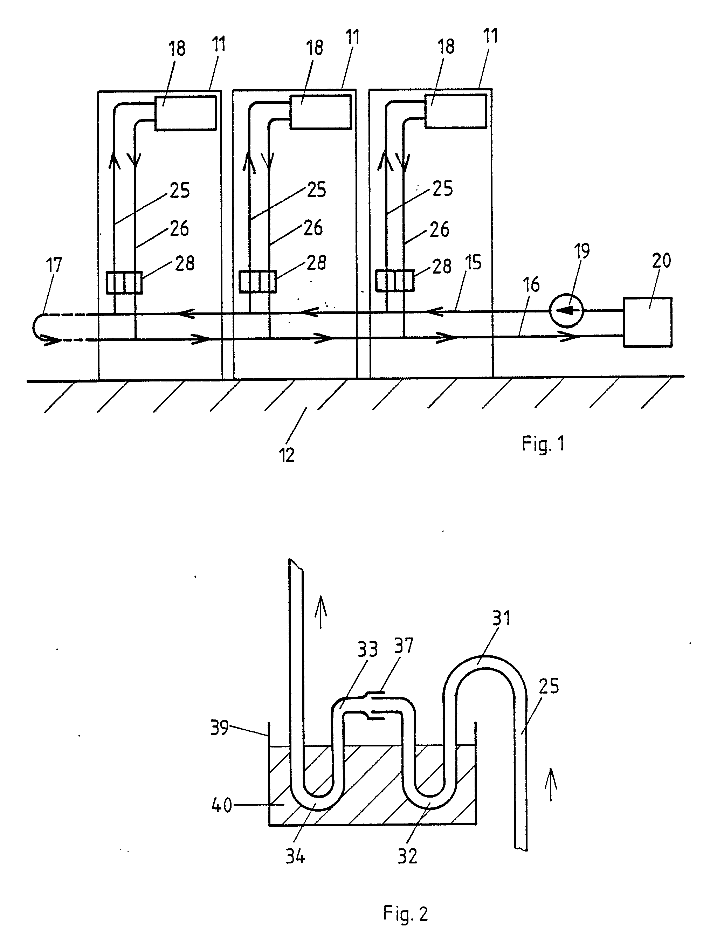

Fig. 1 zeigt schematisch eine Mehrzahl nebeneinander angeordneter Elektronikgestelle 11, in deren Sockelbereich parallel zum Boden 12 zwei Hauptstränge 15, 16 eines Rohrsystems geführt sind. Der eine Hauptstrang 15 dient als Vorlauf für eine Wärmeträgerflüssigkeit, der andere 16 als Rücklauf.

Von beiden Hauptsträngen 15, 16 zweigen in Form von Seitenarmen Steigrohre 25, 26 ab, die bevorzugt zueinander parallel auf einer Seite jedes Elektronikgestells 11 geführt sind und im Topbereich jedes Gestells 11 an einen Wärmetauscher 18 angeschlossen sind. Die Fliessrichtung der nicht gezeigten Wärmeträgerflüssigkeit, bevorzugt Wasser, ist durch Pfeile angedeutet.

Am einen Ende der Hauptstränge 15, 16 sind Anschlüsse vorgesehen zur Verlängerung der Hauptstränge. Weiter kann ein Verbindungsstück 17 vorgesehen sein, das die beiden Hauptstränge 15, 16 verbindet und damit einen Bypass bildet. Am anderen Ende der Hauptstränge 16, 17 ist eine Umwälzpumpe 19 und ein weiterer Wärmetauscher 20 angeschlossen. Die Einheiten 15 bis 20 und 25, 26 bilden damit ein Rohrsystem mit geschlossenem Flüssigkeitskreislauf, das in die Elektronikgestelle 11 eingreift.

Im Bereich der Anschlüsse der Seitenarme an die Hauptstränge 15, 16 ist in den Steigrohren 25, 26 je eine Solltrennstelle 28 vorgesehen. Sofern der jeweilige Wärmetauscher 18 aus einem der Elektronikgestelle 11 herausgenommen werden muss, lassen sich die Steigrohre 25, 26 an den zugeordneten Solltrennstellen 28 relativ bequem von den Hauptsträngen 15, 16 abtrennen und ein neuer Wärmetauscher 18 als Ersatz anschliessen.

Fig. 2 zeigt schematisch eine erste Ausführungsform einer Solltrennstelle 28. Diese besteht aus Biegungen das jeweiligen Rohres, z.B. 25. Diese Biegungen sind so geartet, dass sie in Form eines doppelten Siphons zwei obenliegende Krümmungen 31, 33 und zwei untenliegende Krümmungen 32, 34 in wechselnder Reihenfolge bilden. Im Bereich der Krümmung 33 ist eine gelötete Rohrverbindung 37 angeordnet, beispielsweise als Anschlussstutzen mit erweitertem Durchmesser, der über ein Rohrende mit Normaldurchmesser gesteckt und weich verlötet ist. Alle Krümmungen 31 bis 34 liegen im wesentlichen in einer gemeinsamen Ebene.

Die beiden untenliegenden Krümmungen 32, 34 sind so ausgebildet, dass über sie von unten her ein oben offenes Gefäss 39 geschoben werden kann, das mit einem Kältemittel 40 gefüllt ist, beispielsweise mit Trockeneis. Hierbei bleiben die obenliegenden Krümmungen 31, 33 und die Rohrverbindung 37 ausserhalb des Gefässes 39.

Nachdem in den untenliegenden Krümmungen 32, 34 die Wärmeträgerflüssigkeit eingefroren und hierdurch das Rohr 25 an zwei Stellen abgedichtet ist, kann die Rohrverbindung 37 aufgelötet und können die nunmehr getrennten Rohrhälften auseinandergezogen werden, wobei die untenliegenden Krümmungen 32, 34 weiterhin im Kontakt mit dem Kältemittel 40 bleiben.

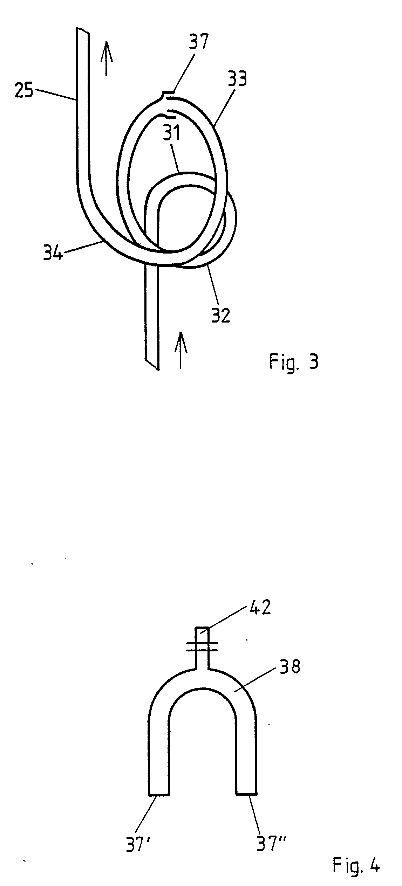

Fig. 3 zeigt schematisch eine zweite Ausführungsform einer Solltrennstelle 28 in angedeutet perspektivischer Ansicht. Die Solltrennstelle 28 besteht ebenfalls aus Biegungen des jeweiligen Rohres, z.B. 25. Diese Biegungen sind jedoch so geartet, dass die obenliegenden 31, 33 und die untenliegenden Krümmungen 32, 34 zusammen zwei kreisförmige Rohrschleifen bilden, die parallel zueinander in zwei getrennten Ebenen liegen. Die von den beiden untenliegenden Krümmungen 32, 34 begrenzte obenliegende Krümmung 33 umfasst die Rohrverbindung 37 und reicht weiter nach oben als die andere obenliegende Krümmung 31. Hierdurch ist Arbeitsraum geschaffen für das Löten der Rohrverbindung 37, der nicht durch die andere obenliegende Krümmung 31 behindert wird.

In jedem der Elektronikgestelle 11 sind entsprechend Fig. 1 zwei Rohre 25, 6 angeordnet, die zum Auswechseln eines Wärmetauschers 18 gemeinsam bzw. gleichzeitig an ihren Solltrennstellen 28 getrennt bzw. angeschlossen werden müssen. Die Solltrennstellen 28 nach Fig. 2 oder 3 sind daher weiter so ausgebildet, dass die insgesamt vier untenliegenden Krümmungen 32, 34 beider Rohre 25, 26 jeweils gemeinsam vom Gefäss 39 umfasst werden.

In diesem allgemeinen Fall ist es vorteilhaft, dass die Rohrverbindungen 37 des Rohres 25 und des Rohres 26 durch verschiedene Ausbildung der zugeodneten obenliegenden Krümmungen 33 auf verschiedenem Niveau liegen. Deshalb sind insgesamt drei verschieden grosse Rohrschleifen gegeben, so dass sich die beiden Rohrverbindungen 37 ohne Beeinflussung durch die anderen Schleifen einzeln bearbeiten lassen.

Die beschriebenen Solltrennstellen 28 sind einfach im Aufbau und damit billig. Sie erfüllen alle eingangs gestellten Anforderungen.

Sie weisen aber den Nachteil auf, dass zum Lösen bzw. zum Schliessen der Rohrverbindungen 37 die obenliegenden Krümmungen 33 in horizontaler Richtung auseinander gezogen bzw. zusammengesteckt werden müssen, was störende Rückwirkungen auf die untenliegenden, im Gefäss 39 befindlichen Krümmungen 32, 34 hat.

Fig. 4 zeigt hierzu eine Lösung. Diese besteht darin, dass statt der jeweils einzigen Rohrverbindung 37 zwei Rohrverbindungen 37′, 37″ vorgesehen werden, die durch ein U-förmiges Rohrstück 38 mit parallelen Schenkeln miteinander verbunden sind. Bei gleichzeitigem Lösen beider Rohrverbindungen 37′, 37″ lässt sich das Rohrstück 38 ohne weiteres nach oben abziehen bzw. zum Befestigen von oben her aufstecken.

Das Rohrstück 38 bildet im montierten Zustand jeweils eine obenliegende Krümmung 33. An dieser kann leicht eine Druckentlastungsvorrichtung 42, z.B. ein Ventil oder ein abgequetschbares Rohrstück, angebracht sein, die beim Löten entstehende Überdrücke abbaut.

Die beschriebene Solltrennstelle 28 ist nur vorgeshen für seltene Bedarfsfälle. Tritt ein solcher auf, dann kann die Solltrennstelle 28 unter Benutzung eines billigen Gefässes 39 und eines beliebigen Kältemittels 40 sowie ohne spezielle Werkzeuge beim Beheben des Schadens durchaus hilfreich sein. Die Verwendung der Solltrennstellen 28 ist somit einfach und im räumlich beengten Gebiet eines Elektronikgestelles 11 praktizierbar.

Die spezielle Form der Krümmungen 31 bis 34 bestimmt sich nach praktischen Erfordernissen. Die Form muss jedoch so geartet sein, dass die Rohrverbindungen 37 stets ausserhalb des Gefässes 39 verbleibt, dass die räumliche Anordnung genügend Arbeitsplatz verfügbar lässt und dass die beim Löten auftretende Wärme die in den untenliegenden Krümmungen 32, 34 eingefrorene Wärmeträgerflüssigkeit nicht zum Schmelzen bringt.

In analoger Weise wie beschrieben lassen sich die Solltrennstellen 28 einsetzen, wenn die Hauptstränge 15, 16 im Topbereich der Elektronikgestelle 11 vorgesehen sind anstatt in deren Sockelbereich.

Statt der beschriebenen gelöteten Rohrverbindungen 37 können ohne weiteres Steck- oder Schraubverbindungen bekannter Art vorgesehen werden.

**Ansprüche**

1. Solltrennstelle (28) zum gleichzeitigen Abtrennen zweier Rohre (25, 26) von zwei Hauptsträngen (15, 16),

wobei die Rohre (25, 26) und die Hauptstränge (15, 16) Bestandteil eines Rohrsystems mit geschlossenem Flüssigkeitskreislauf sind,

wobei die Rohre (25, 26) in einem Elektronikgestell angeordnet sind, und wobei das Abtrennen ohne Betriebsunterbruch des Flüssigkeitskreislaufes in den Hauptsträngen (15, 16) erfolgt,

bestehend aus Biegungen jedes der zwei Rohre (25, 26), derart, dass sich jeweils zwei obenliegende (31, 33) und zwei untenliegende Krümmungen (32, 34) einzeln abwechseln,

und bestehend aus jeweils wenigstens einer lösbaren Rohrverbindung (37) im Bereich jeweils derjenigen obenliegenden Krümmung (33), die von den beiden zugeordneten untenliegenden Krümmungen (32, 34) begrenzt wird,

wobei die untenliegenden (32, 34) und die obenliegenden Krümmungen (31, 33) so ausgebildet sind, dass von unten her ein oben offenes Gefäss (39) gemeinsam über alle untenliegenden Krümmungen (32, 34) schiebbar ist, derart, dass hierbei die obenliegenden Krümmungen (31, 33) ausserhalb des Gefässes (39) verbleiben und die Rohrverbindungen (37) einzeln frei zugänglich sind.

2. Solltrennstelle (28) nach Anspruch 1,
dadurch gekennzeichnet,
dass die Biegungen der Rohre (25, 26) so ausgebildet sind, dass die obenliegenden (31, 33) und die untenliegenden Krümmungen (32, 34) in Form eines doppelten Siphons in einer Ebene liegen (Fig.2).

3. Solltrennstelle (28) nach Anspruch 1,
dadurch gekennzeichnet,
dass die Biegungen der Rohre (25, 26) so ausgebildet sind, dass die obenliegenden (31, 33) und die untenliegenden Krümmungen (32, 34) zusammen zwei kreisförmige Rohrschleifen bilden, die in zwei Ebenen hintereinander liegen (Fig.3).

4. Solltrennstelle (28) nach Anspruch 3,
dadurch gekennzeichnet,
dass die Rohrschleife, die die Rohrverbindung (37) umfasst, grösser als die zugeordnete andere Rohrschleife ist (Fig. 3).

5. Solltrennstelle nach Anspruch 1,
dadurch gekennzeichnet,
dass für jedes der Rohre (25, 26) zwei lösbare Rohrverbvindungen (37', 37'') vorgesehen sind, die über ein U-förmiges Rohrstück (38) mit parallelen Schenkeln miteinander verbunden sind (Fig. 4).

6. Solltrennstelle nach Anspruch 5,
dadurch gekennzeichnet,
dass das U-förmige Rohrstück (38) eine oben liegende Druckentlastungsvorrichtung (42) trägt (Fig. 4).

7. Solltrennstelle (28) nach Anspruch 1,
dadurch gekennzeichnet,
dass die Rohrverbindungen (37', 37'. 37'') Lötverbindungen sind.

8. Verwendung der Solltrennstelle (28) nach Anspruch 1 in einem Elektronikgestell (11) zum Abtrennen bzw. Auswechseln eines Wärmetauschers (18), der über Rohre (25, 26) mit den Hauptsträngen (15, 16) eines geschlossenen Kühlrohrsystems verbunden ist,

wobei der Kreislauf der Wärmeträgerflüssigkeit in den Hauptsträngen (15, 16) voll erhalten bleibt,

dadurch gekennzeichnet,

dass ein Kältemittel (40) über ein oben offenes Gefäss (39) mit den untenliegenden Krümmungen (32, 34) der Solltrennstellen (28) beider Rohre (25, 26) in Kontakt gebracht wird zum Verschliessen beider Rohre (25, 26) in den untenliegenden Krümmungen (32, 34) durch Einfrieren der in ihnen enthaltenen Wärmeträgerflüssigkeit, und dass nach dem Verschliessen der Rohre (25, 26) die Rohrverbindungen (37) aufgetrennt werden.

Fig. 1

Fig. 2

25

37

33

31

34

32

Fig. 3

42

38

37'

37"

Fig. 4